# EUROPÄISCHE PATENTSCHRIFT

(11) **EP 2 248 175 B1**
(45) Veröffentlichungstag und Bekanntmachung des Hinweises auf die Patenterteilung: **29.03.2017**
(21) Anmeldenummer: 09714298.8
(22) Anmeldetag: 25.02.2009
(51) Int. Cl.: H01L 27/15, H01L 33/38, H01L 33/62

(54) **OPTOELEKTRONISCHER HALBLEITERKÖRPER UND VERFAHREN ZUR HERSTELLUNG EINES SOLCHEN**
OPTOELECTRONIC SEMI-CONDUCTOR BODY AND METHOD FOR THE PRODUCTION THEREOF
COMPOSANT SEMICONDUCTEUR OPTOÉLECTRONIQUE ET PROCÉDÉ DE FABRICATION

(30) Priorität: 29.02.2008 DE 102008011848
(43) Veröffentlichungstag der Anmeldung: 10.11.2010
(73) Patentinhaber: OSRAM Opto Semiconductors GmbH, 93055 Regensburg (DE)
(72) Erfinder: ENGL, Karl, 93080 Niedergebraching (DE); RODE, Patrick, 93051 Regensburg (DE); HÖPPEL, Lutz, 93087 Alteglofsheim (DE); STRASSBURG, Martin, 93105 Tegernheim (DE)
(74) Vertreter: Epping - Hermann - Fischer
(86) Internationale Anmeldenummer: PCT/DE2009/000281
(87) Internationale Veröffentlichungsnummer: WO 2009/106069

(56) Entgegenhaltungen:
- US-A- 5 952 681
- US-A1- 2005 035 354
- US-A1- 2007 090 377
- US-A1- 2007 131 958
- US-A1- 2007 284 598

## Beschreibung

Die Erfindung betrifft einen optoelektronischen Halbleiterkörper gemäß Anspruch 1 sowie ein Verfahren gemäß Anspruch 10 zur Herstellung eines optoelektronischen Halbleiterkörpers.

Die Druckschriften US 2007/0284598, DE 2007/090377, US 5,952,681 A, US 2005/035354 A1 und US 2007/131958 A1 beschreiben optoelektronische Halbleiterbauelemente. Optoelektronische Halbleiterkörper werden für eine Vielzahl verschiedener Lichtanwendungen verwendet. Sie bieten sich vor allem an, wenn eine hohe Lichtausbeute auf einem geringen Raum erforderlich ist. Beispiele für die Verwendung von optoelektronischen Halbleiterkörpern finden sich in Projektionsanwendungen und auch im Automotivbereich, dort unter anderem in der Verwendung von Frontscheinwerfern.

Dennoch bleibt das Bedürfnis, optoelektronische Halbleiterkörper anzugeben, die gegenüber herkömmlichen Beleuchtungsmitteln eine verbesserte Effizienz bei gleichzeitig geringerer Komplexität aufweisen.

Diese Aufgaben werden durch einen optoelektronischen Hableiterkörper und durch ein Verfahren zum Herstellen eines solchen gemäß den unabhängigen Patentansprüchen gelöst. Ausgestaltungen und Weiterbildungen der Erfindung sind jeweils Gegenstand der Unteransprüche, deren Offenbarungsgehalt hiermit ausdrücklich in die Beschreibung mit aufgenommen wird.

Nach dem vorgeschlagenen Prinzip umfasst in einer Ausführungsform ein optoelektronischer Halbleiterkörper eine im Wesentlichen flächig angeordnete Halbleiterschichtfolge mit einer ersten und einer zweiten Hauptseite sowie eine zur Erzeugung elektromagnetischer Strahlung geeignete aktive Schicht.

Die aktive Schicht kann hierbei einen pn-Übergang, eine Doppelheterostruktur, einen Einfachquantentopf (SQW, single quantum well) oder eine Mehrfachquantentopfstruktur (MQW, multi quantum well) zur Strahlungserzeugung aufweisen. Die Bezeichnung Quantentopfstruktur entfaltet keinerlei Bedeutung hinsichtlich der Dimensionalität der Quantisierung. Sie umfasst im Allgemeinen unter anderem Quantentröge, Quantendrähte und Quantenpunkte sowie jede Kombination dieser Strukturen. Beispiele für Mehrfachquantentopfstrukturen sind in den Druckschriften WO 01/39282, US 5,831,277, US 6,172,382 sowie US 5,684,309 beschrieben. Deren Offenbarungsgehalt wird hiermit durch Rückbezug aufgenommen.

In der Ausgestaltung ist die erste Hauptseite zur Emission elektromagnetischer Strahlung vorgesehen. Des Weiteren ist zumindest die aktive Schicht der Halbleiterschichtenfolge durch einen die aktive Schicht durchdringenden Graben in wenigstens zwei elektrisch voneinander isolierte aktive Teilschichten unterteilt. Mit anderen Worten durchtrennt der Graben die aktive Schicht der Halbleiterschichtenfolge wodurch elektrisch voneinander isolierte aktive Teilschichten in der Halbleiterschichtenfolge ausgebildet sind.

Der optoelektronische Halbleiterkörper umfasst weiterhin jeweils eine auf der zweiten Hauptseite angeordnete erste und zweite Anschlussschicht zur Kontaktierung der aktiven Teilschichten. Dabei bedeutet der Begriff einer auf der zweiten Hauptseite angeordnete Anschlussschicht, dass zumindestens ein Teil der ersten beziehungsweise zweiten Anschlussschicht der Halbleiterschichtfolge in Richtung von der Vorderseite zur Rückseite hin nachfolgt. Es ist dabei jedoch nicht notwendig, dass die erste beziehungsweise zweite Anschlussschicht direkt auf der zweiten Hauptseite der Halbleiterschichtenfolge aufgebracht ist. Auch muss die erste und zweite Anschlussschicht die zweite Hauptseite der Halbleiterschichtenfolge nicht vollständig überdecken. Vielmehr sind die erste und zweite Anschlussschicht zur Kontaktierung der aktiven Teilschichten zumindest teilweise auf der zweiten Hauptseite angeordnet. Sie sind somit der zweiten Hauptseite näher als der ersten Hauptseite der Halbleiterschichtenfolge.

Erfindungsgemäß sind die ersten und zweiten Anschlussschichten welche jeweils die wenigstens zwei elektrisch isolierten aktiven Teilschichten kontaktierend derart miteinander elektrisch leitend verbunden, dass die aktiven Teilschichten eine Serienschaltung bilden.

Mit anderen Worten sind die beiden Anschlussschichten der aktiven Teilschichten so miteinander verbunden, dass die aktiven Teilschichten eine Serienschaltung bilden.

Der optoelektronische Halbleiterkörper ist somit in Teilbereiche aufgeteilt, die elektrisch miteinander unter Bildung einer Serienschaltung durch die verschiedenen Anschlussschichten verbunden sind. Damit wird erreicht, dass der optoelektronische Halbleiterkörper in einem Betrieb einen deutlich geringeren Stromfluss aufweist. Vielmehr sind nun mehr die einzelnen aktiven Teilbereiche in einer Serienschaltung miteinander verbunden. Der optoelektronische Halbleiterkörper kann somit spannungsgetrieben bei gleichzeitig niedrigen Strömen gespeist werden. Dadurch lassen sich beispielsweise teure Treiberstufen sowie Hochstromquellen durch entsprechende Hochspannungsquellen ersetzen, welche leichter zu fertigen sind. Durch die Unterteilung in Teilbereiche kann der optoelektronische Halbleiterkörper somit mit verschiedenen abhängig von der Unterteilung wählbaren Spannungen betrieben werden.

Zweckmäßigerweise ist der Halbleiterkörper monolithisch ausgebildet, das heißt er umfasst lediglich einen Körper, in dem alle Leitungsebenen, sowie aktive Schichten integriert sind und währendder Herstellung nacheinander implementiert werden. Dies erlaubt eine großflächige Herstellung über den gesamten Wafer hinweg, einschließlich einer Ausbildung der aktiven Schichten und der Leitungsebenen auf einem gemeinsamen Substrat.

In einer Ausgestaltung ist der Halbleiterkörper ein Dünnfilm-Leuchtdiodenchip. Insbesondere weist er an seiner Rückseite ein Trägersubstrat auf. Bei einer Ausgestaltung sind die erste und die zweite Anschlussschicht zumindest stellenweise zwischen der Halbleiterschichtenfolge und dem Trägersubstrat angeordnet. Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;

- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

In einer weiteren Ausgestaltung verläuft der Graben im Wesentlichen senkrecht zur aktiven Schicht der Halbleiterschichtenfolge. Er kann vollständig durch die aktive Schicht der Halbleiterschichtenfolge verlaufen.

Der Graben kann mit einem elektrisch isolierenden Material gefüllt sein und im Bereich von wenigen Mikrometern Dicke liegen. Vorzugsweise durchdringt er zumindest den Bereich der aktiven Schicht, in dem eine Rekombination der Ladungsträger und damit die Erzeugung elektromagnetischer Strahlung erfolgt. Alternativ kann der Graben senkrecht durch einen großen Bereich der Halbleiterschichtenfolge verlaufen und damit die Halbleiterschichtenfolge in Teilbereiche mit jeweils einer aktiven Teilschicht unterteilen. Dadurch werden Leckströme zwischen den einzelnen Teilbereichen beziehungsweise den aktiven Teilschichten verringert. Beispielsweise kann der Graben auch senkrecht zumindestens eine der beiden Anschlussschichten durchtrennen.

In einer Ausgestaltung ist die erste Anschlussschicht zur Kontaktierung einer ersten der wenigstens zwei aktiven Teilschichten mit der zweiten Anschlussschicht zur Kontaktierung einer zweiten der wenigstens zwei Teilschichten elektrisch leitend verbunden. Mit anderen Worten wird somit der n-dotierte Bereich einer ersten aktiven Teilschicht durch die Anschlussschicht mit einem p-dotierten Bereich einer zweiten aktiven Teilschicht elektrisch leitend verbunden. Dadurch bildet sich eine Serienschaltung aus den beiden aktiven Teilschichten aus.

Für eine Kontaktierung der aktiven Teilschichten ist in einer Ausgestaltung vorgesehen einen zweiten Teilbereich der zweiten Anschlussschicht von der zweiten Hauptseite her durch einen Durchbruch der aktiven Teilschicht hindurch zur ersten Hauptseite hin zu erstrecken. Es werden somit durch die aktive Teilschicht hindurch Durchbrüche ausgebildet, mit der sich der Bereich der aktiven Teilschicht zur ersten Hauptseite hin kontaktieren lässt.

Vorteilhafterweise ist die lichtemittierende erste Hauptseite der Halbleiterschichtenfolge und des optoelektronischen Bauelements frei von elektrischen Kontaktstellen. Die Gefahr einer Abschattung beziehungsweise Absorption eines Teils der von der aktiven Teilschicht im Betrieb emittierten elektromagnetischen Strahlung durch die elektrische Kontaktstelle wird auf diese Weise reduziert. In einer Ausgestaltung der Erfindung umfassen somit die jeweils erste und zweite elektrische Anschlussschicht Teilbereiche, die mit Kontaktstellen auf der der ersten Hauptseite abgewandten Seite des Halbleiterkörpers verbunden sind. Alternativ ist in einer Ausgestaltung der Erfindung eine Kontaktfläche auf der ersten Hauptseite des Halbleiterkörpers neben einem strahlungsemittierenden Bereich ausgestaltet. Dieser ist mit der ersten und/oder der zweiten Anschlussschicht elektrisch leitend gekoppelt.

Bevorzugt kann die erste beziehungsweise die zweite elektrische Anschlussschicht mit einer leitenden Spiegelschicht ausgestaltet sein, so dass elektromagnetische Strahlung die in Richtung der zweiten Hauptseite hin in Richtung der ersten Hauptseite reflektiert wird. In einer anderen Ausgestaltung ist zwischen der Halbleiterschichtenfolge und/oder der zweiten elektrischen Anschlussschicht wenigstens stellenweise eine Spiegelschicht angeordnet. Diese kann halbleitend oder auch elektrisch isolierend sein. In letzterem Fall kann sie eine Mehrzahl von Öffnungen aufweisen, durch die die erste und/oder die zweite elektrische Anschlussschicht die Halbleiterschichtenfolge und die aktiven Teilschichten kontaktieren. Ebenso kann eine laterale Stromverteilungsschicht zwischen der Halbleiterschichtenfolge und der ersten Anschlussschicht vorgesehen sein, um eine Stromeinkopplung zu verbessern. Die Stromaufweitungsschicht kann ein leitfähiges Oxid umfassen jedoch auch eine Spiegelschicht aufweisen und somit als Reflexionsschicht dienen.

Alternativ kann die aktive Schicht der Halbleiterschichtenfolge mehrere übereinander gestapelte aktive Teilschichten umfassen. Beispielsweise kann die aktive Schicht eine Doppelheterostruktur oder Mehrfachquantenwell beinhalten. Darüber hinaus können Teilbereiche der aktiven Schicht unterschiedlich dotiert sein, so dass bei einer Rekombination elektromagnetische Strahlung unterschiedlicher Wellenlänge emittiert wird. Beispielsweise können die aktiven Teilschichten in den unterschiedlichen Teilbereichen unterschiedlich dotiert sein, so dass elektromagnetische Strahlung unterschiedlicher Wellenlänge in die einzelnen Teilbereiche emittiert wird.

Zur Verbesserung der Emission kann die erste Hauptseite der Schichtenfolge strukturiert sein. Ebenso ist es möglich, auf die erste Hauptseite ein Konversionsmaterial aufzubringen, um so die emittierte elektromagnetische Strahlung in eine zweite Strahlung unterschiedlicher Wellenlänge zu verwandeln. Bei einem entsprechend geeigneten Konversionsmaterial sowie bestimmten Materialsystemen für die aktive Schicht kann dadurch weißes Licht beispielsweise für Frontscheinwerfer oder Projektionssysteme erzeugt werden.

Der erfindungsgemäße optoelektronische Halbleiterkörper wird in einer Ausgestaltung durch ein epitaktisches Aufwachsen einer Halbleiterschichtenfolge auf einem Aufwachssubstrat erzeugt. Dabei wird die Halbleiterschichtenfolge unter Bildung einer zur Erzeugung von elektromagnetischer Strahlung geeigneten aktiven Schicht aufgewachsen. Weiterhin werden eine erste elektrische Anschlussschicht an einer der ersten Hauptseite abgewandten Seite der Halbleiterschichtenfolge zur Kontaktierung der aktiven Schicht sowie eine Trennschicht und eine zweite elektrische Anschlussschicht aufgebracht, wobei die erste elektrische Anschlussschicht, die Trennschicht und die zweite elektrische Anschlussschicht zumindestens teilweise lateral überlappend ausgebildet werden.

Weiterhin umfasst das Verfahren den Schritt eines Ausbildens eines elektrisch isolierenden Grabens zumindestens in der aktiven Schicht der Halbleiterschichtenfolge zur Unterteilung der Halbleiterschichtenfolge und insbesondere der aktiven Schicht in wenigstens zwei aktive Teilschichten. Mit diesem Schritt wird somit die Halbleiterschichtenfolge in Teilbereiche mit jeweils einer aktiven Teilschicht unterteilt. Diese aktiven Teilschichten sind durch die erste und zweite Anschlussschicht derart kontaktiert, dass die zwei aktiven Teilschichten eine Serienschaltung bilden.

Zweckmäßigerweise erfolgt das Ausbilden eines elektrisch isolierenden Grabens nach dem Aufbringen der ersten elektrischen Anschlussschicht, wodurch die erste elektrische Anschlussschicht ebenfalls unterteilt wird. Im weiteren Verlauf wird dann die erste elektrische Anschlussschicht eines ersten Teilbereichs beziehungsweise kontaktierend einer ersten aktive Teilschicht mit der zweiten elektrischen Anschlussschicht eines zweiten Teilbereichs beziehungsweise kontaktierend einer zweiten aktiven Teilschicht elektrisch leitend gekoppelt. Dadurch werden die beiden aktiven Teilschichten in Serie miteinander verschaltet.

In einer Ausgestaltung des Verfahrens erfolgt ein Ausbilden eines Durchbruchs in der aktiven Schicht sowie ausbilden eines Teilbereichs der zweiten elektrischen Anschlussschicht in dem Durchbruch, wobei die zweite elektrische Anschlussschicht mittels der Trennschicht von der ersten elektrischen Anschlussschicht elektrisch isoliert wird. Durch den Teilbereich kontaktiert die zweite elektrische Anschlussschicht die aktive Schicht und insbesondere die aktiven Teilschichten. Hierzu kann in jedem durch die Gräben gebildeten Teilbereich der Halbleiterschichtenfolge beziehungsweise der aktiven Teilschichten ein Durchbruch in der jeweiligen aktiven Teilschicht vorgesehen werden.

Der elektrisch isolierende Graben und der Durchbruch können hierzu durch ein gemeinsam durchgeführtes Ätzen der aktiven Schicht erzeugt werden.

In einer anderen Ausgestaltung wird die erste elektrische Anschlussschicht reflektierend ausgebildet, so dass elektromagnetische in der aktiven Schicht erzeugte Strahlung emittiert in Richtung der der ersten Hauptseite abgewandten Seite von der ersten elektrischen Anschlussschicht in Richtung der ersten Hauptseite reflektiert wird.

In einer Weiterbildung wird auch in der Trennschicht ein Durchbruch eingearbeitet und dieser mit einem Material gefüllt, der die erste Anschlussschicht die eine erste aktive Teilschicht kontaktiert mit der zweiten Anschlussschicht elektrisch leitend verbindet, die eine zweite aktive Teilschicht kontaktiert. Auf diese Weise wird eine Verbindung zwischen denen durch den Graben getrennten aktiven Teilschichten erzeugt. Diese können dann beispielsweise in einer Serien- und/oder Parallelschaltung weiter verschaltet werden.

Wieder in einer anderen Ausgestaltung werden Kontaktpanele auf der der ersten Hauptseite abgewandten Seite ausgebildet, die jeweils die erste und zweite Anschlussschicht kontaktierend die einzelnen aktiven Teilschichten elektrisch verbinden. Demzufolge kann durch die einzelnen Kontaktpanele jede aktive Teilschicht einzeln mit Strom beaufschlagt werden. Dies ermöglicht eine selektive Ansteuerung der einzelnen Teilbereiche der Halbleiterschichtenfolge. In einer externen Elektronik können somit die aktiven Teilschichten der Halbleiterschichtenfolge in den Teilbereichen je nach gewünschtem Anwendungsfall seriell beziehungsweise parallel verschaltet werden.

Bei einer weiteren Ausgestaltung des Verfahrens wird nach dem Aufwachsen der Halbleiterschichtenfolge wenigstens ein Teil des Aufwachssubstrats entfernt. Dieses Entfernen kann vor oder nach dem Aufbringen der einzelnen Anschlussschichten erfolgen. Beispielsweise kann es insbesondere nach einer Unterteilung in einzelne Teilbereiche und einer anschließenden Kontaktierung der einzelnen Teilbereiche durchgeführt werden. Das Aufwachssubstrat kann abgesprengt werden, etwa mittels eines Laser-Abhebeverfahrens.

Vor dem Entfernen des Aufwachssubstrats kann in einer Ausgestaltung an der Rückseite des Halbleiterkörpers ein Trägersubstrat angeordnet werden. Bei diesem kann es sich um ein separates Trägerelement handeln, dass beispielsweise mittels einer Lot- beziehungsweise Klebstoffschicht mit der Halbleiterschichtenfolge verbunden wird. Zudem kann das Trägersubstrat einen Teil der ersten und/oder zweiten Anschlussschicht darstellen. Bei einer weiteren Ausgestaltung wird an der Rückseite der Halbleiterschichtenfolge stellenweise eine halbleitende oder elektrisch isolierende Spiegelschicht ausgeführt. Bei dieser können Öffnungen in de Spiegelschicht vorgesehen werden, durch die die aktive Schicht mit der ersten und/oder zweiten Anschlussschicht elektrisch verbunden werden kann. Damit enthalten die erste und/oder die zweite elektrische Anschlussschicht jeweils Teilbereiche, die durch die Öffnungen der Spiegelschicht hindurch verlaufen.

Im Folgenden wird die Erfindung anhand verschiedener Ausgestaltung unter Bezugnahme auf die Zeichnungen im Detail erläutert.

Es zeigen:
- Figur 1A bis 1G: ein Ausführungsbeispiel eines Verfahrens zur Herstellung eines optoelektronischen Halbleiterkörpers nach dem vorgeschlagenen Prinzip,
- Figur 2: eine Schnittdarstellung eines optoelektronischen Halbleiterkörpers gemäß einer weiteren Ausführungsform,
- Figur 3: eine Schnittdarstellung eines optoelektronischen Halbleiterkörpers gemäß einer dritten Ausführungsform,
- Figur 4A, 4B: schematische Schnittdarstellungen gemäß einer Ausführungsform,
- Figur 4C, 4D: Ersatzschaltbilder der Ausführungsformen in den Figuren 4A, B,
- Figur 4E, F: Draufsichten über einen optoelektronischen Halbleiterkörper unterteilt in vier Teilbereiche korrespondierend zu den Schnittdarstellungen und den Ersatzschaltbildern der Figuren 4A bis D,
- Figuren 5A, B: Draufsichten über einen optoelektronischen Halbleiterkörper mit Ausgestaltungen von Durchbrüchen durch die aktive Schicht.

In den Ausführungsbeispielen sind die Größenverhältnisse der dargestellten Elemente grundsätzlich nicht als maßstabsgerecht zu betrachten. Vielmehr können einzelne Elemente etwa Schichten zum besseren Verständnis und/oder zur besseren Darstellbarkeit übertrieben groß beziehungsweise dick dargestellt sein.

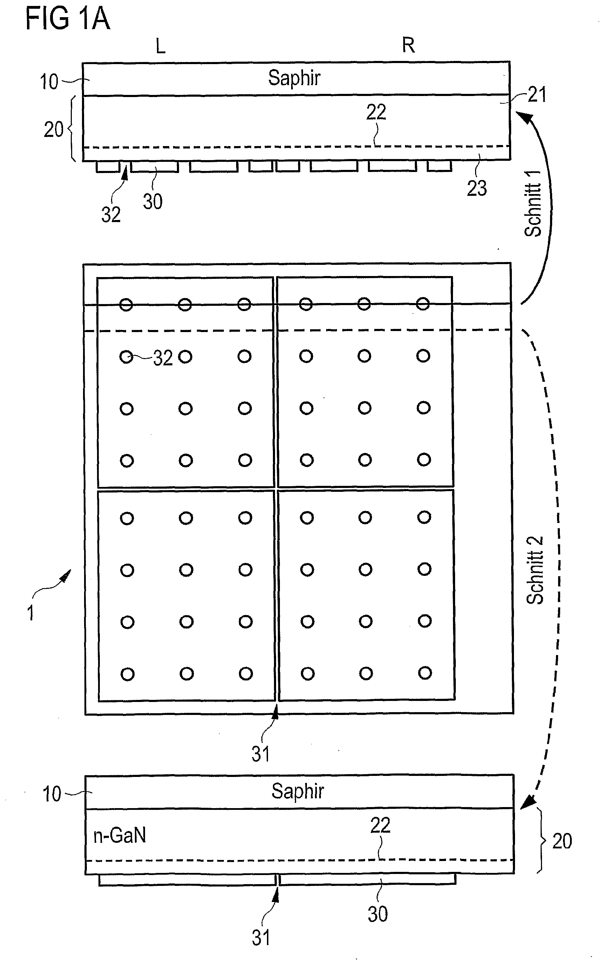

Figur 1A bis 1G zeigt ein Ausführungsbeispiel eines Verfahrens zur Herstellung eines monolithischen optoelektronischen Halbleiterkörpers nach dem vorgeschlagenen Prinzip.

Unter dem Begriff monolithisch wird eine Herstellung verstanden, bei dem einzelne Schichten nicht getrennt voneinander hergestellt werden. Vielmehr erfolgt ein Abscheiden oder ausbilden von Schichten, unabhängig davon, welche Funktion sie erfüllen, auf einer in einem vorangegangenen Prozessschritt hergestellten Schicht. Dadurch wird in aufeinanderfolgenden Schritten ein Halbleiterkörper nach dem vorgeschlagenen Prinzip hergestellt.

Dargestellt sind schematische Schnittdarstellungen sowie Draufsichten in verschiedenen Stadien des Verfahrens. Im Besonderen ist zur Verdeutlichung der durch die Anschlussschichten erzeugten Serienschaltung jeweils zwei Schnittfiguren gekennzeichnet durch die durchgezogene beziehungsweise gestrichelte Linie dargestellt.

Bei dem Verfahren wird zunächst eine Halbleiterschichtenfolge 20 auf einem Aufwachssubstrat 10 epitaktisch aufgewachsen.

Die Halbleiterschichtenfolge 20 basiert auf einem Halbleitermaterialsystem welches je nach Anwendung unterschiedlich dotiert sein kann. Beispielsweise können so genannte III/V-Verbindungs-Halbleiter oder auch II/VI-Verbindungs-Halbleiter verwendet werden. Die Halbleiterschichtenfolge 2 hat vorliegend eine Dicke zwischen fünf Mikrometer und sieben Mikrometer.

Ein III/V-Verbindungs-Halbleitermaterial weist wenigstens ein Element aus der dritten Hauptgruppe, wie beispielsweise Al, Ga, In, und ein Element aus der V-Hauptgruppe, wie beispielsweise B, N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, insbesondere Nitrid- und Phosphid-Verbindungs-Halbleiter. Eine solche binäre, ternäre oder quaternäre Verbindung kann zudem beispielsweise ein oder mehrere Dotierstoffe sowie zusätzliche Bestandteile aufweisen. Zu den III/V-Verbindungs-Halbleitermaterial gehören beispielsweise Nitrid-III-Verbindungs-Halbleitermaterial und Phosphid-III-Verbindungs-Halbleitermaterial, etwa GaN, GaAs, und InGaAlP. Ebenso wird das Materialsystem AlGaN/GaN zu den oben genannten Verbindungshalbleitern gezählt.

Entsprechend weist ein II/VI-Verbindungs-Halbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Zu den II/VI-Verbindungs-Halbleitermaterialen gehören zum Beispiel ZnO, ZnMgO, CdS, CnCdS, MgBeO.

Abhängig von der gewünschten Wellenlänge oder dem gewünschten Wellenlängenspektrum können eine oder auch mehrere der oben genannten Verbindungen als Materialsystem für ein optoelektronisches Bauelement bereitgestellt werden.

Die dargestellte Halbleiterschichtenfolge 20 weist eine erste n-dotierte Schicht 21 auf, die dem Aufwachssubstrat 10 beispielsweise aus Saphir benachbart aufgewachsen ist. Abhängig von der gewünschten Anwendung kann diese Dotierung gleichmäßig in der Schicht 21 jedoch auch einen graduellen Unterschied aufweisen. Hieran angeschlossen ist eine p-dotierte Schicht 23, die somit auf der von dem Aufwachssubstrat 10 abgewandten Seite der Halbleiterschichtenfolge 20 angeordnet ist. Durch die verschiedene Dotierung der beiden Schichten 21 und 23 bildete sich zwischen ihnen eine aktive Zone 22 aus. Die Dicke dieser aktiven Zone 22 ist abhängig von der Dotierung der beiden aufgewachsenen Schichten 21 und 23. In einem späteren Betrieb der Anordnung rekombinieren die in die Schichten 21 und 23 injizierten Ladungsträger im pn-Übergang 22 und emittieren dabei abhängig von der Bandlücke des verwendeten Halbleitersystems elektromagnetische Strahlung. Man spricht daher bei der Schichtenfolge 21 und 23 auch von einer aktiven Schicht. Diese ist vorliegend gleichmäßig über den optoelektronischen Halbleiterkörper hin angeordnet.

In einer alternativen Ausgestaltung ist die Halbleiterschichtenfolge 2 als npn-Schichtenfolge ausgebildet, bei der auf der von der n-dotierten Schicht 21 abgewandten Seite der p-dotierten Schicht 23 eine weitere n-dotierte Schicht ausgebildet ist. Bei einer anderen Ausgestaltung ist die p-dotierte Schicht 23 dem Aufwachssubstrat 10 benachbart und die n-dotierte Schicht 21 von dem Aufwachssubstrat 10 abgewandt.

In einer anderen Variante wird vor dem Aufwachsen der Halbleiterschichtenfolge 20 eine zusätzliche Pufferschicht auf dem Aufwachssubstrat 10 dem Saphir aufgebracht. Dies erlaubt es, die Gitterkonstante der späteren zu wachsenden Schichtenfolge an das Aufwachssubstrat 10 anzupassen, so dass Spannungen und mögliche Fehlstellen in der Schichtenfolge reduziert werden. Zusätzlich kann diese Pufferschicht undotiert oder schwach n-dotiert sein beispielsweise in der Konzentration von 2 x 10¹⁷ Atome/cm³ oder weniger. Eine derartige Pufferschicht ist zwar nicht geeignet, vom Betriebsstrom des Halbleiterkörpers durchflossen zu werden, jedoch verringert diese bei dem fertig gestellten Halbleiterkörper die Gefahr einer Beschädigung oder Zerstörung durch eine elektrostatische Entladung.

In der Ausgestaltung des Verfahrens wird nach Beendigung der Herstellung der Halbleiterschichtenfolge 20 eine leitende Kontaktschicht 30 auf der p-dotierten Schicht 23 der Halbleiterschichtenfolge aufgebracht. Diese leitende Schicht 30 kann zudem reflektierend sein, so dass bei einem späteren Betrieb emittierte elektromagnetische Strahlung in Richtung auf die elektrisch leitende Schicht 30 von dieser reflektiert und in die gewünschte Richtung abgestrahlt wird. Das leitende Material kann beispielsweise Silber oder ein anderes reflektierendes Metall umfassen.

Anschließend wird mittels einer Fotomaske die leitende Schicht 30 strukturiert und so beispielsweise kreisförmige regelmäßig angeordnete Kontaktöffnungen 32 gebildet. Dies ist in der Draufsicht des Halbleiterkörpers 1 in der mittleren Darstellung zu erkennen. Des Weiteren wird in die leitende Schicht 30 ein Graben 31 geätzt, so dass die elektrisch leitende Schicht wie vorliegend dargestellt in vier Teilbereiche unterteilt wird. Diese Teilbereiche korrespondieren zu der späteren Unterteilung des optoelektronischen Halbleiterkörpers in vier Teilbereiche. Zur Verdeutlichtung sind in den beiden Schnittdarstellungen der rechte Teilbereich des optoelektronischen Halbleiterkörpers mit R und der linke Teilbereich des Halbleiterkörpers mit L bezeichnet.

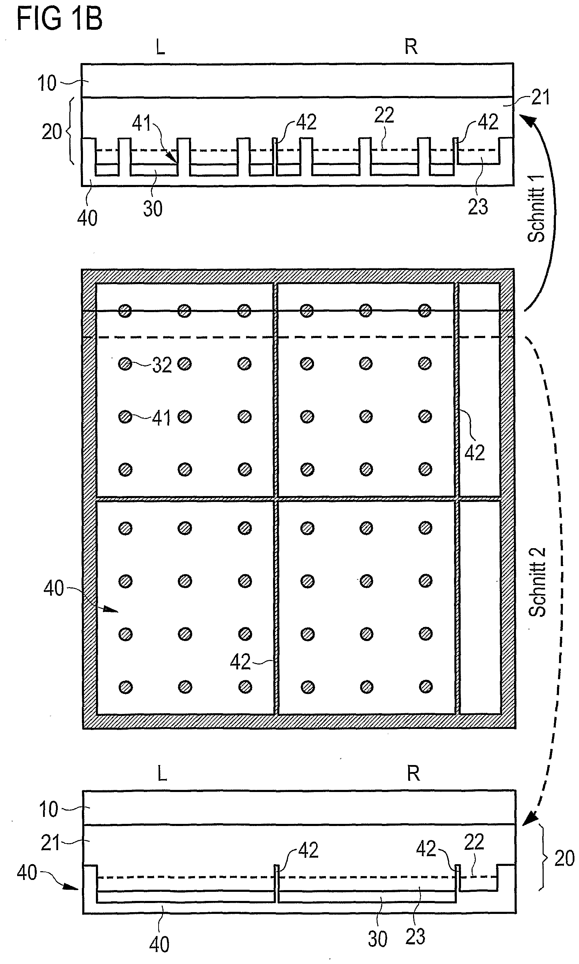

Anschließend wird gemäß Figur 1B in der Halbleiterschichtenfolge mehrere Durchbrüche zur Kontaktierung der Schicht 21 ausgebildet. Dies erfolgt beispielsweise durch ein geeignetes Ätzen der Halbleiterschichtenfolge, wobei die darauf aufgebrachte strukturierte Metallisierung als Ätzmaske dienen kann. Die einzelnen Durchbrüche 41 gehen durch den pn-Übergang 22 der Halbleiterschichtenfolge 2 hindurch und kontaktieren somit die n-dotierte Schicht 21. Des Weiteren wird auch der Bereich des Grabens 31 der metallischen Schicht geätzt, so dass sich in der Halbleiterschichtenfolge ein ebenfalls durch die aktive Schicht hindurch erstreckender Graben 42 ausbildet.

Durch geeignete Maßnahmen ist es zudem möglich, die Durchbrüche zur Kontaktierung der Halbleiterschicht 21 in einer gewissen Tiefe zu stoppen, während der Graben 42 eine deutlich größere Tiefe erreicht. Beispielsweise wird der Ätzvorgang bei Erreichen der ersten Tiefe der Durchbrüche 41 gestoppt, dann diese mittels Photomaske abgedeckt und der Graben 42 bis zur Endtiefe weiter geätzt. Natürlich können Graben und Durchbrüche auch erstmals gleiche Tiefe aufweisen. Mit Hilfe der neu ausgebildeten Gräben 42 wird der optoelektronische Halbleiterkörper in eine Vielzahl von Teilbereichen untertellt, wobei die aktive Schicht 22 entsprechend in aktive Teilschichten getrennt wird. Durch die Erzeugung mehrerer Durchbrüche 41 in den verschiedenen Teilbereichen des optoelektronischen Halbleiterkörpers wird zudem eine homogene laterale Stromverteilung in der n-dotierten Schicht 21 erzielt.

Nach Beendigung der verschiedenen Ätzverfahren zur Erzeugung des Grabens 42 und der Durchbrüche 41 wird eine nichtleitende Schicht 40 aufgebracht, welche die Gräben 42 sowie die Durchbrüche 41 füllt. Diese isolierende Schicht kann beispielsweise transparent ausgestaltet sein, so dass wie in der Figur 1B in der Draufsicht dargestellt die einzelnen Gräben 42 sowie die Durchbrüche 32 weiterhin erkennbar sind.

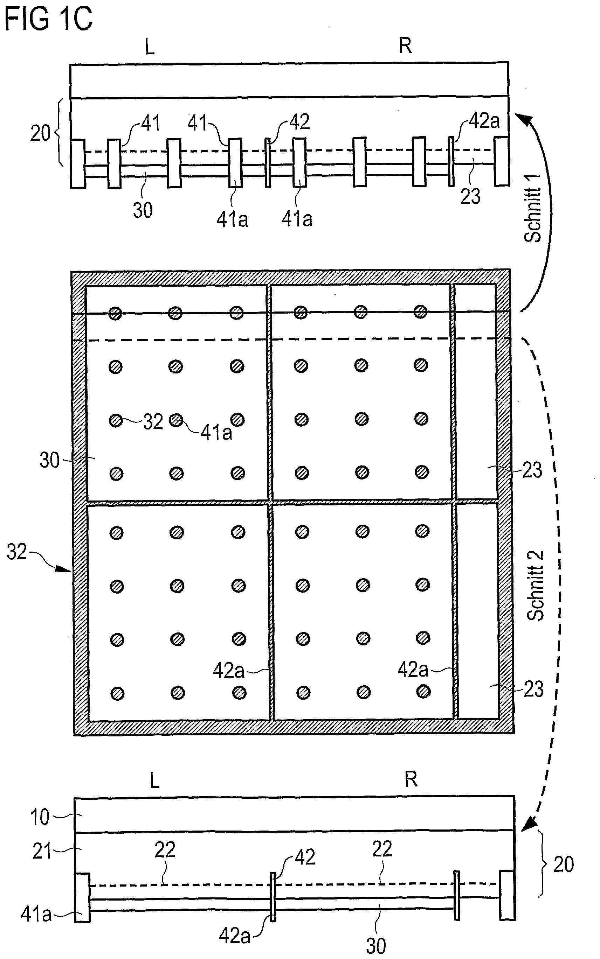

In einem nächsten Schritt wird gemäß Figur 1C die isolierende Schicht im Bereich der elektrisch leitenden Schicht 30 sowie im äußeren rechten Teil des optoelektronischen Halbleiterkörpers mit Hilfe einer Fotomaske entfernt. Im Bereich der Durchbrüche 41 sowie der Gräben 42 bleibt das isolierende Material hingegen erhalten, so dass sich entsprechende Säulen 41a, 42a ausbilden. Ebenso liegt die zweite Schicht 23 der Halbleiterschichtenfolge 20 im rechten Bereich des optoelektronischen Halbleiterkörpers frei. Diese dient später zur Kontaktierung der Halbleiterschichtenfolge für einen Betrieb des Halbleiterkörpers. In der Draufsicht sind nunmehr die freiliegenden Stege 42a im Bereich der Gräben 42 sowie die Säulen 41a im Bereich der Durchbrüche 41 zu erkennen.

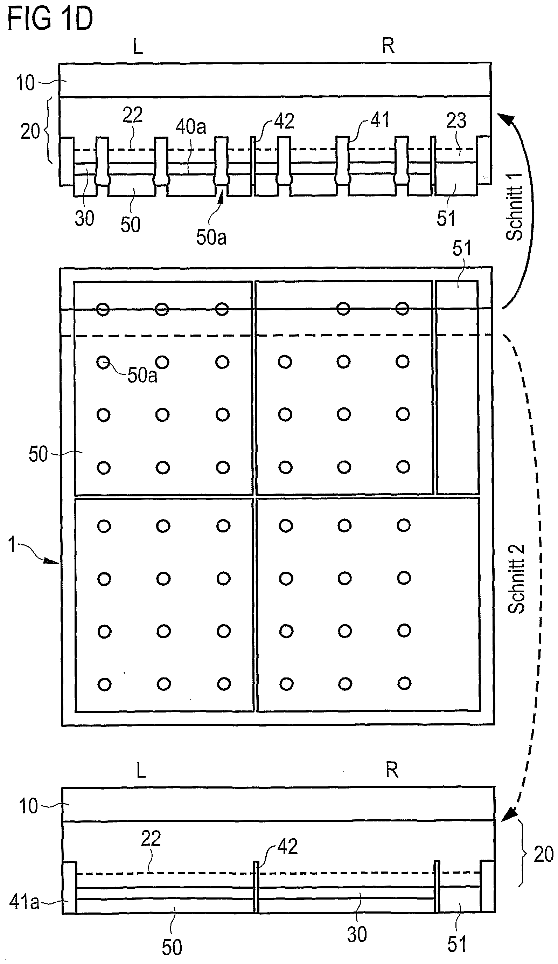

Nach einer Entfernung des isolierenden Materials außerhalb der Gräben 42 und der Durchbrüche 41 wird wie in Figur 1D dargestellt eine weitere leitende Kontaktierungsschicht 50 aufgebracht und strukturiert, so dass sich in diese Öffnungen 50a im Bereich der Durchbrüche 41 sowie der Gräben 42 ausbilden. Ebenso wird entsprechend elektrisch leitendes Material 51 auf die zweite Schicht 23 der Halbleiterschichtenfolge 20 im rechten Bereich des optoelektronischen Halbleiterkörpers aufgebracht. Das Material der Schichten 50 bildet später eine der beiden Anschlussschichten zur Kontaktierung der Teilschichten.

Entsprechend ist wie in den Schnittdarstellungen Schnitt 1 und Schnitt 2 zu erkennen, die metallische Kontaktierung 50 im Bereich der Gräben 42 sowie der Durchbrüche 41 unterbrochen. Dies ist in der Aufsicht in Figur 1D deutlich zu erkennen. Der rechte untere Teilbereich des optoelektronischen Halbleiterkörpers Figur 1D bildet später ein erstes Kontaktpanel, während das im Bereich 51 abgeschiedene Material ein zweites Kontaktpanel darstellt.

Die in den bisherigen Verfahrensschritten aufgebrachten leitenden Schichten 30 und 50 können beispielsweise aufgedampft werden und verschiedene Dicken aufweisen. So kann unter anderem die Schicht 30 dünner ausgebildet sein, als die leitende Schicht 50. Darüber hinaus kann die leitende Schicht 30 auch als Stromaufweitungsschicht zu einer möglichst guten lateralen Verteilung späterer zu indizierender Ladungsträger geeignet sein. Beide Schichten können die gleiche als auch unterschiedliche Materialien aufweisen.

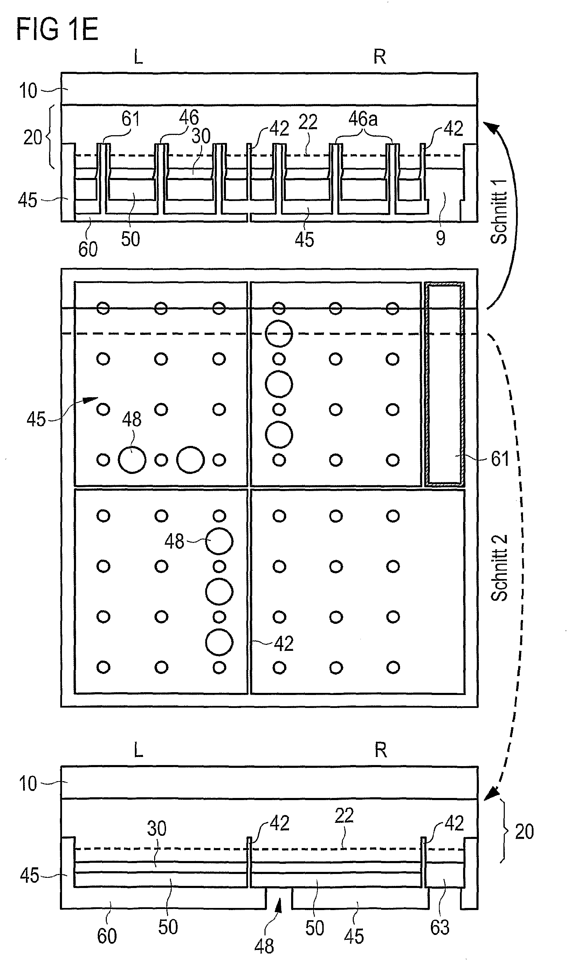

Gemäß Figur 1E wird nunmehr eine isolierende Schicht 45 auf die leitenden Materialien 50 und 51 aufgebracht. Im Bereich 51 wird diese isolierende Schicht wieder entfernt. Vorzugsweise wird als isolierende Schicht das gleiche Material verwendet, welches auch die Durchbrüche 40 und die Gräben 42 füllt. Anschließend wird mittels einer Fotomaske das isolierende Material 45 in den Durchbrüchen 41 geätzt und teilweise entfernt. An den Wänden der Durchbrüche 41 bleibt jedoch weiterhin isolierendes Material vorhanden. Der Ätzvorgang kann anisotrop erfolgen und entfernt in der Mitte des Grabens das isolierende Material bis zum Boden der Durchbrüche 41. Die weiterhin isolierenden Seitenwände in den Durchbrüchen verhindern, dass das im nächsten Schritt eingebrachte Material 60 einen Kurzschluss mit den einzelnen Schichten der Halbleiterschichtenfolge 2 verursacht.

Demzufolge wird in den Durchbrüchen eine Trennschicht auf einem Teil der Oberfläche der Durchbrüche ausgebildet. Diese Trennschicht bedeckt die umlaufende Seitenwand beziehungsweise die Seitenwände der Durchbrüche 42 zumindest stellenweise in den Bereichen der metallischen Schicht 30, der Kontaktierungsschicht 50 sowie der Schicht 23 der Schichtenfolge 20. Die Trennschicht 45 bedeckt zudem die Kontaktierungsschicht 50 und füllt den Graben 42 vollständig aus.

Anschließend werden die Durchbrüche 41 mit einem Material 60 aufgefüllt, so dass sich Kontaktierungselemente 46 für die erste Schicht 21 der Halbleiterschichtenfolge 20 ergeben. Gemäß der Schnittdarstellung Schnitt 1 in Figur 1E ist der Kontaktierungsbereich 63 vollständig mit dem leitenden Material 60 gefüllt, so dass dieser einen elektrischen Kontakt mit der ersten Schicht 21 über die Kontaktelemente 46a bildet. Zwischen dem rechten und dem linken Teilbereich des optoelektronischen Halbleiterkörpers ist zudem die Schicht 60 im Bereich des Grabens 42 getrennt.

In der Draufsicht auf den optoelektronischen Halbleiterkörper sind des Weiteren Öffnungen 48 dargestellt. Diese werden wie in der Schnittdarstellung Schnitt 2 durch Löcher gebildet, die in der Passivierungsschicht 45 ausgeführt sind und bis zur Kontaktierungsschicht 50 reichen.

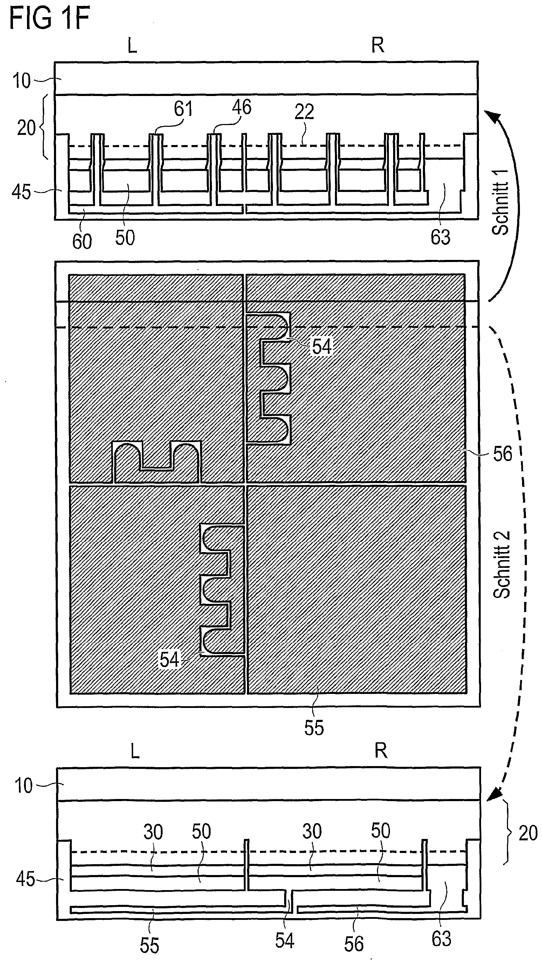

Figur 1F zeigt die Struktur nach weiteren Herstellungsschritten. Auf die Schicht 60, welche den Bereich 63 mit den Gräben 42 eines jeden Teilbereichs kontaktiert wird eine Passivierungsschicht aufgebracht. Diese ist aus dem gleichen Material wie die Schicht 45, wobei die Löcher 48 weiterhin ausgespart werden. Diese werden in den darauf folgenden Schritten wie aus der Darstellung des Schnitts 2 ersichtlich mit einem leitenden Material 54 aufgefüllt. Des Weiteren wird eine Materialschicht 55 auf der Oberfläche der Passivierungsschicht abgeschieden, wobei sich zwischen einem Teilbereich 56 des Materials, welches mit dem Anschluss 63 verbunden ist und dem Material des Bereichs 55 kein elektrischer Kontakt ergibt. Dies kann beispielsweise durch ein flächiges Auftragen des Materials in die Löcher sowie auf die Oberfläche der Passivierungsschicht 45 und einer anschließenden Strukturierung erfolgen.

Die Schicht des Teilbereichs 56 ist elektrisch leitend sowohl mit der Schicht 60 verbunden, welche die Durchbrüche 46 kontaktiert. Sie bildet somit eine erste Anschlussschicht zur Kontaktierung der Schicht 21 der Schichtenfolge 20. Entsprechend bilden die Schichten 50 des rechten Teilbereichs R eine zweite Anschlussschicht zur Kontaktierung über die Zwischenschicht 30 der Halbleiterschichtenfolge 20. Die zweite Anschlussschicht 50 des rechten Teilbereichs R ist über das Element 54 mit der Schicht 55 im linken Teilbereich L des optoelektronischen Halbleiterkörpers verbunden. Die Schicht 55 ist wiederum elektrisch leitend mit der Schicht 60 des linken Teilbereichs L kontaktiert, welche die Durchbrüche 46 im linken Teilbereich L des optoelektronischen Halbleiterkörpers kontaktiert.

Entsprechend bilden die Schichten 55 und 60 des linken Teilbereichs L eine erste Anschlussschicht des linken Teilbereichs zur Kontaktierung der aktiven Teilschicht im optoelektronischen Halbleiterkörper. Daraus ergibt sich dass in der gezeigten Serienschaltung die zweite Anschlussschicht eines Teilbereichs des optoelektronischen Halbleiterkörpers mit der ersten Anschlussschicht eines zweiten Teilbereichs des optoelektronischen Halbleiterkörpers und der Bildung einer Serienschaltung verschaltet ist.

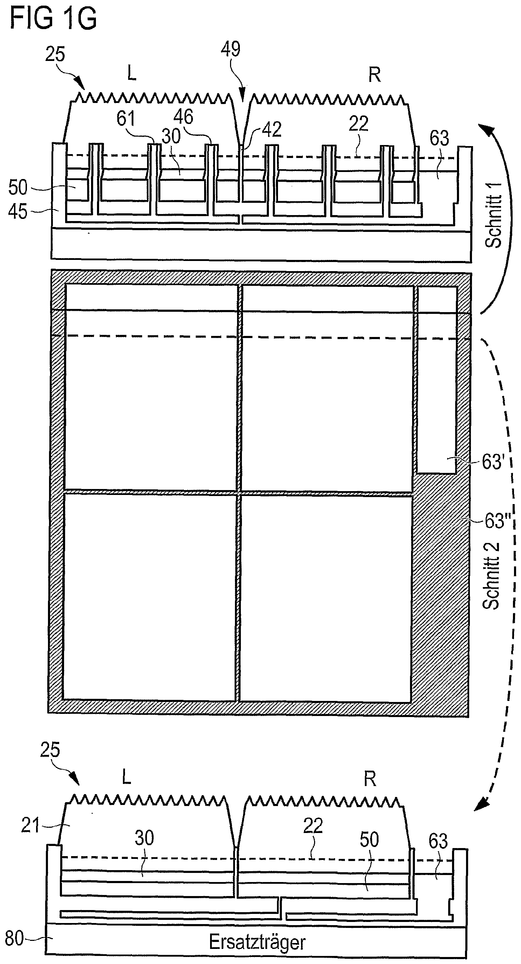

In einem nachfolgenden Verfahrensschritt gemäß Figur 1G wird nachfolgend auf der vom Aufwachssubstrat 10 abgewandten Rückseite der Halbleiterschichtenfolge 2 ein Ersatzträger 80 mittels einer Lot- oder Klebstoffschicht befestigt. Der Ersatzträger kann hierzu beispielsweise aus Aluminiumnitrid oder einem anderen Material bestehen. Insbesondere isolierende Ersatzträgersubstrate 80 etwa Glasträgersubstrate sind hierzu geeignet.

In einem nachfolgenden Verfahrensschritt wird das Aufwachssubstrat 10 gedünnt und anschließend vollständig entfernt. Dies kann beispielsweise mittels eines dem Fachmann im Prinzip bekannten Laser-Abhebeverfahrens erfolgen. Hierzu kann das Aufwachssubstrat 10 beziehungsweise die Halbleiterschichtenfolge 20 eine zusätzliche Opferschicht aufweisen, die bei Bestrahlung mit einem Laser zersetzt wird. Dadurch wird das Aufwachssubstrat 10 gesprengt.

Anschließend wird die dem Ersatzträger 80 abgewandten Seite der Halbleiterschichtenfolge 20 um Auskoppelstrukturen 25 ergänzt. Des Weiteren wird im Bereich des Grabens 42 die Halbleiterschichtenfolge von der Oberseite her entfernt, so dass sich ein grabenförmiger Spalt 49 ausbildet. Dieser trennt nunmehr die Teilbereiche der Halbleiterschichtenfolge des optoelektronischen Halbleiterkörpers vollständig, so dass Leckströme vermieden werden. Der Spalt 49 kann wiederum mit einem isolierenden Material gefüllt werden, beispielsweise SiO₂.

Zudem wird im Bereich des Anschlusskontaktes 63 die Halbleiterschichtenfolge entfernt, so dass die Oberfläche des Materials frei liegt. Dieser bildet ein erstes Kontaktpanel 63' zur Kontaktierung. In einem weiteren Bereich des Halbleiterkörpers, in dem das Material der Halbleiterschichtenfolge ebenfalls entfernt ist wird ein zweites Kontaktpanel 63" ebenfalls zur Kontaktierung ausgebildet. Durch die Serienschaltung der vier Teilbereiche des optoelektronischen Halbleiterkörpers können alle vier Teilbereiche durch die Kontaktpanels 63' und 63" mit dem für den Betrieb notwendigen Strom versorgt werden.

Der in Figur 1G dargestellte optoelektronische Halbleiterkörper ist dazu vorgesehen in den vier Teilbereichen im Betrieb erzeugte elektromagnetische Strahlung in Richtung der strukturierten Seite der Halbleiterschichtenfolge zu emittieren. Elektromagnetische Strahlung die im Bereich des pn-Übergangs 22 in Richtung auf den Ersatzträger 80 hinemittiert wird, wird an der elektrisch leitenden Zwischenschicht in Richtung der strukturierten Seite der Schichtenfolge 20 reflektiert. Durch die Unterteilung in vier Teilbereiche wird der für den Betrieb notwendige Strom des optoelektronischen Halbleiterkörpers verringert, dafür jedoch aufgrund der Serienschaltung die für den Betrieb notwendige Spannung erhöht. In diesem Ausführungsbeispiel ist das optoelektronische Bauelement in vier Teilbereiche unterteilt, wodurch die Einsatzspannung um den Faktor vier erhöht und gleichzeitig der Stromverbrauch um den entsprechenden Faktor gesenkt wird. Bei einem Materialsystem basierend auf InGaN lässt sich in dieser Ausgestaltung ein lichtemittierendes Bauelement mit einer Betriebsspannung von zwölf Volt realisieren.

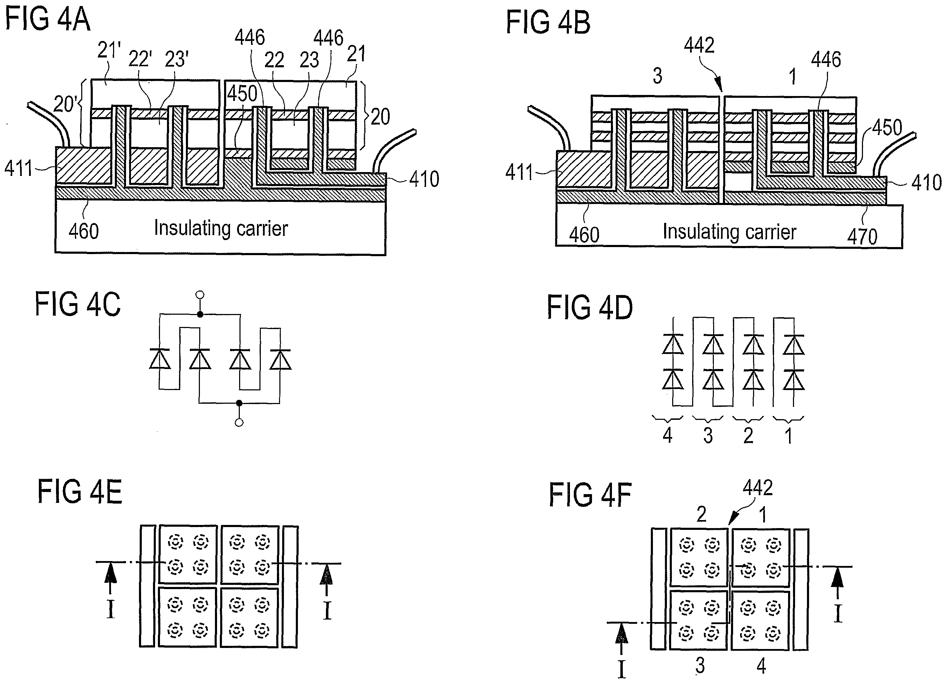

Diesbezüglich zeigen die Figuren 4A bis 4F eine schematische Darstellung einer Ausführungsform nach dem vorgeschlagenen Prinzip. Figur 4A ist eine Schnittdarstellung durch einen optoelektronischen Halbleiterkörper entlang der in Figur 4E gezeigten Richtung. Eine Kontaktierung erfolgt jeweils im Randbereich durch die Kontaktelemente 410 beziehungsweise 411. Das Kontaktelement 410 ist mit den Durchbrüchen 446 elektrisch leitend verbunden, welche die Schicht 21 der Halbleiterschichtenfolge 20 kontaktieren. Zwischen den beiden unterschiedlich dotierten Schichten 21 und 23 bildet sich ein pn-Übergang 22 aus, in der die im Betrieb injizierten Ladungsträger rekombinieren und elektromagnetische Strahlung emittieren. Auf die Schicht 23 ist zudem eine laterale Stromverteilungsschicht 450 angeordnet, die aus dem gleichen Material besteht wie die Kontaktschicht 411 des zweiten Teilbereichs des elektronischen Halbleiterkörpers.

Eine zweite Anschlussschicht 460 kontaktiert die Stromverteilungsschicht 450 des rechten Teilbereichs des optoelektronischen Halbleiterkörpers und bildet die Durchbruchskontaktierung für die Schicht 21' der Halbleiterschichtenfolge im linken Teilbereich des optoelektronischen Halbleiterkörpers. Entsprechend ist die zweite Anschlussschicht 410 mit der zweiten Schicht 23' der Halbleiterschichtenfolge 20' verbunden.

Zwischen dem linken und dem rechten Teilbereich des optoelektronischen Halbleiterkörpers ist wie in der Schnittfigur 4A sowie in der Draufsicht der Figur 4E dargestellt ein isolierender Graben vorgesehen. Dadurch werden die Teilbereiche elektrisch voneinander getrennt. Im Ersatzschaltbild gemäß Figur 4C sind somit jeweils zwei Dioden in Serie geschaltet. Die Diodenwirkung ergibt sich dabei aus dem dargestellten pn-Übergang der Halbleiterschichtenfolge 20 beziehungsweise 20'.

Figur 4B zeigt eine alternative Ausgestaltung, bei der anstelle eines einfachen pn-Übergangs mehrere pn-Übergänge vorgesehen sind. Diese Übergänge wirken wie zwei hintereinander geschaltete Dioden, wie sich aus dem Ersatzschaltbild nach Figur 4D ergibt.

Die Darstellung des Schnitts gemäß Figur 4B erfolgt entlang der Achsen I wie in Figur 4F gezeigt. In diesem Ausführungsbeispiel ist der optoelektronische Halbleiterkörper in vier Teilbereiche unterteilt, die jeweils von einem Graben 442 isolierend getrennt sind. Die verschiedenen Anschlussschichten 410, 411, 460 und 450 kontaktieren jeweils die Halbleiterschichtenfolgen der verschiedenen Teilbereiche und die darin befindlichen pn-Übergänge. Die Anschlussschichten 410, 411, 450 bis 470 sind dabei derart ausgestaltet, dass sie die vier Teilbereiche wie in dem Ersatzschaltbild gemäß Figur 4D erläutert verschalten.

Dadurch wird bei dem optoelektronischen Halbleiterkörper nach dem vorgeschlagenen Prinzip eine Serienschaltung aus vier jeweils zwei hintereinander geschalteten Dioden realisiert. Im Betrieb der Anordnung wird demzufolge eine höhere Betriebsspannung notwendig. Durch die elegante Kombination aus Serienschaltungen in der Epitaxieschicht können teure Treiberstufen und Hochstromquellen eingesetzt werden, da die Leistungen nunmehr spannungsgetrieben bei niedrigen Strömen in den optoelektronischen Halbleiterkörper gespeist wird. Zudem ergibt sich eine optimierte Flächennutzung durch Vermeidung von absorbierenden Kontakten, da alle lichterzeugenden Bestandteile stromsparend auf einem einzelnen Halbleiterkörper realisierbar sind. Zudem lässt sich eine Serienschaltung von Chips auch nur mit nur einem Topkontakt und einem leitenden Träger ausführen.

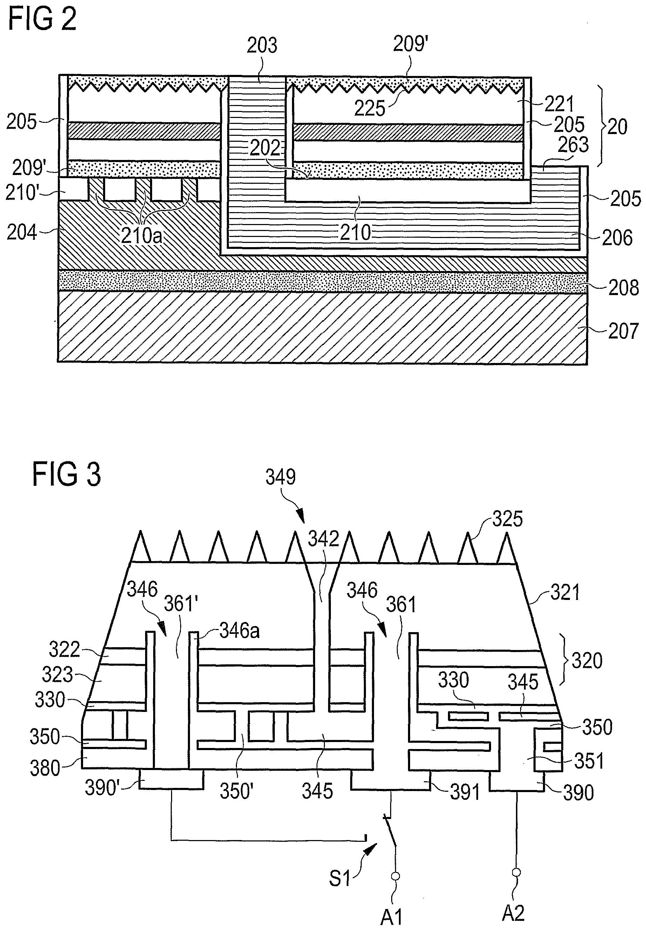

Ein derartiges Beispiel ist in Figur 2 dargestellt.

Das Bauelement nach dem vorgeschlagenen Prinzip ist als monolithischer Halbleiterkörper ausgeführt, d.h. die einzelnen Schichten wurden als aufeinander aufgebracht und nicht in einzelnen getrennten Prozessen hergestellt und anschließend miteinander verbunden. Dadurch wird die Genauigkeit verbessert und auch die Stabilität erhöht.

Im Gegensatz zu den vorhergehenden Ausführungsbeispielen ist der Durchbruch 203 in dem Ausführungsbeispiel gemäß Figur 2 durch die aktive Zone 200 als ein über die gesamte Dicke der Halbleiterschichtenfolge verlaufender Durchbruch ausgeführt. Der Durchbruch 203 erstreckt sich also vorliegend von der ersten Hauptfläche an der Oberseite bis hinunter zur zweiten Hauptfläche 202 der Halbleiterschichtenfolge. Er bildet ein Loch in der Halbleiterschichtenfolge 200.

Auf der strukturierten Oberseite 225 der Halbleiterschichtenfolge 200 ist eine weitere Stromaufweitungsschicht 209 aufgebracht. Diese ist zusätzlich zu der an der Rückseite der Halbleiterschichtenfolge vorgesehenen Stromaufweitungsschicht 209 angeordnet. Beide Stromaufweitungsschichten dienen dazu, eine möglichst gute laterale Stromverteilung und Stromeinkopplung in die Halbleiterschichtenfolge zu gewährleisten. Dadurch wird die Effizienz des Bauelementes erhöht und andererseits eine lokale Erwärmung durch einen zu großen Stromfluss in die Halbleiterschichtenfolge vermieden. Hierzu weisen die Stromaufweitungsschichten einen möglichst geringen lateralen Flächenwiderstand auf.

Daneben kann die Stromaufweitungsschicht 209' zusätzlich als transparentes Material beispielsweise in Form eines transparenten leitfähigen Oxids wie ITO ausgeführt sein. Die Stromaufweitungsschicht 209 auf der der Emissionsrichtung abgewandten Seite kann bevorzugt reflektierend jedoch auch transparent ausgeführt sein. In letzteren Fall weist wie dargestellt der optoelektronische Halbleiterkörper eine zusätzliche Spiegelschicht 210 auf. Diese ist bevorzugt nicht-leitend ausgeführt, sofern nicht eine zusätzliche isolierende Passivierungsschicht zwischen der Spiegelschicht 210 und dem Material der Anschlussschicht 203 vorgesehen ist. In einer Ausführungsform kann die Spiegelschicht 210 das gleiche Material wie die Trennschichten 205 umfassen. Dadurch werden die Reflexionseigenschaften auch bei einer Abstrahlung parallel zur aktiven Schicht der Halbleiterschichtenfolge durch Reflexionen an den Seitenwänden verbessert.

Zur Kontaktierung ist die Stromaufweitungsschicht über Zuführungsdurchbrüche 210a mit der elektrischen Anschlussschicht 204 verbunden. Diese ist über eine elektrische Zwischenschicht 208 mit einem Kontaktelement 207 auf der Rückseite gekoppelt. Das Kontaktelement 207 bildet gleichzeitig auch das Ersatzträgersubstrat für den optoelektronischen Halbleiterkörper.

In dem Ausführungsbeispiel nach Figur 2 ist lediglich ein erster Teilbereich des Halbleiterkörpers gezeigt. Ein weiterer Teilbereich des Halbleiterkörpers schließt sich linksseitig an den hier dargestellten ersten Teilbereich an. Dieser ist so ausgeführt, dass die zweite Anschlussschicht 204 mit einem nicht gezeigten Durchbruch in der Halbleiterschichtenfolge 200 elektrisch leitend verbunden ist. Dieses kontaktiert die erste Schicht 221 der Halbleiterschichtenfolge 200 des zweiten Teilbereichs und bildet so eine Serienschaltung. Gleichzeitig bildet das linksseitig angeordnete isolierende Material 205 und 210 den die Halbleiterschichtenfolge in Teilbereiche auftrennenden Graben.

In den bisherigen Ausführungsbeispielen wurde eine Serienschaltung vor allem durch eine entsprechende Anordnung der Anschlussschichten innerhalb des Halbleiterkörpers realisiert. Darüber hinaus ist es jedoch auch denkbar, einen Teil der Serienschaltung beziehungsweise Verschaltungsvarianten extern auszubilden, um so sowohl Serien als auch Parallelschaltung und Kombinationen davon zu realisieren. Dadurch kann durch eine entsprechende Ansteuerelektronik charakteristische Eigenschaften des Halbleiterkörpers je nach Anwendung verändert werden. Beispielsweise ist es denkbar, im Fall von Lichtscheinwerfern durch ein entsprechendes hinzu- beziehungsweise wegschalten einzelner Teilbereiche des Halbleiterkörpers die Lichtstärke zu variieren.

Figur 3 zeigt eine Querschnittsdarstellung einer entsprechenden Ausführungsform. Bei dieser sind ebenfalls alle Kontaktelemente rückseitig angeordnet. Die Halbleiterschichtenfolge 320 enthält wiederum eine erste n-dotierte Schicht 321, an die benachbart eine p-dotierte Schicht 323 aufgebracht ist. An der Grenzfläche bildet sich wie dargestellt ein pn-Übergang 322 aus.

Als Materialsystem der Schichtenfolge kann beispielsweise InGaN/GaN verwendet werden, deren Emissionsspektrum im Bereich des sichtbaren blauen Lichtes liegt. Durch die vorgesehene aufgebrachte Strukturierung 325 wird eine Abstrahlungscharakteristik des optoelektronischen Halbleiterkörpers verbessert. Zudem kann darüber hinaus ein Konversionsmittel vorgesehen und auf der Oberfläche der Strukturierung 325 aufgebracht werden. Dadurch wird ein Teil des emittierten blauen Lichts in Licht einer anderen Wellenlänge konvertiert, wodurch sich die Erzeugung von weißem Licht realisieren lässt.

Auf der der Strukturierung 325 abgewandten Seite der zweiten Schicht 323 der Halbleiterschichtenfolge 320 ist eine leitende reflektierende Anschlussschicht 330 angeordnet. Diese dient gleichzeitig auch als laterale Stromaufweitungsschicht zur Einkopplung von Ladungsträgern. Die Schicht 330 wird durch mehrere Zuleitungselemente 350 kontaktiert, die ihrerseits mit einem Durchbruch 351 an einen rückseitig angeordneten Kontakt 390 angeschlossen sind.

Weiterhin ist ein Durchbruch 346 vorgesehen, der mit einem elektrisch leitenden Material 361 gefüllt ist. Der Durchbruch verläuft von der Rückseite des Halbleiterkörpers durch alle Schichten hindurch bis zur Schicht 321 der Halbleiterschichtenfolge 320. Seine Seitenwände sind im Wesentlichen mit einem isolierenden Material 364 fast vollständig umgeben, um einen Kurzschluss beispielsweise mit der Anschlussschicht 330 zu vermeiden. Des Weiteren ist der Kontakt 361 mit einem rückseitigen Kontakt 391 auf der Rückseite des optoelektronischen Halbleiterkörpers sowie mit einer leitenden Materialschicht 350' verbunden. Diese Materialschicht 350' kontaktiert die Anschlussschicht 330' des linken Teilbereichs des Halbleiterkörpers. Selbiger ist vom rechten Teilbereich durch einen isolierenden Graben 342 elektrisch vollständig getrennt. Der Graben 342 ist mit einem Isolationsmaterial gefüllt, welches auch die Zwischenräume zwischen den einzelnen Durchführungen 350' und 350 auffüllt. Dieses isolierende Material kann gleichzeitig als Trägersubstrat für den Ersatzträger 380 verwendet werden.

Die leitende Schicht 350' bildet gemeinsam mit der Schicht 330' eine erste Anschlussschicht des linken Teilbereichs des optoelektronischen Halbleiterkörpers und kontaktiert die Schicht 323 der Halbleiterschichtenfolge 320. Entsprechend ist auch im linken Teilbereich des Halbeiterkörpers ein Graben 361' ausgebildet, dessen Seitenwände 346a mit einem isolierenden Material versehen sind. Das Material des Grabens 361' kontaktiert auf der rückseitigen Oberfläche befindlichen Kontakt 390'.

Extern sind die Kontakte 390' sowie 391 auf der Rückseite mit einem Schalter S1 gekoppelt, der an einen ersten Anschluss A1 führt. Der Kontakt 390 ist mit einem zweiten Anschluss A2 gekoppelt. In einem Betrieb der Anordnung wird nun abhängig von der Schalterstellung S1 werden nun lediglich der rechte Teil des optoelektronischen Bauelements oder beide Teile des optoelektronischen Bauelements mit Strom versorgt. In der dargestellten Schalterstellung fließt im Betrieb der Halbleiteranordnung ein Strom über den Kontakt 390 und die Zuführung 350 in die Halbleiterschichtenfolge des rechten Bereichs des Halbleiterkörpers. In dem dortigen pn-Übergang rekombinieren die Ladungsträger und emittieren Licht. Während des Betriebs ist in der dargestellten Schalterstellung der linke Teilbereich des Halbleiterkörpers abgeschaltet.

Wird nun der Anschluss A1 mit dem Kontakt 390' über den Schalter S1 gekoppelt, so fließt der Strom über den Graben 361' im rechten Teilbereich des Halbleiterkörpers in die erste Anschlussschicht aus den Schichten 350' und 330' im linken Teilbereich des Halbleiterkörpers. Dadurch sind die beiden Halbleiterschichtenfolge und ihre darin enthaltenen pn-Übergänge in Serie geschaltet.

Abhängig von der Ausgestaltung der einzelnen Anschlussschichten und ihrer Kontaktierung in den jeweiligen Teilbereichen lässt sich so eine externe Parallel- oder Serienschaltung der einzelnen Teilbereiche eines optoelektronischen Halbleiterkörpers erreichen.

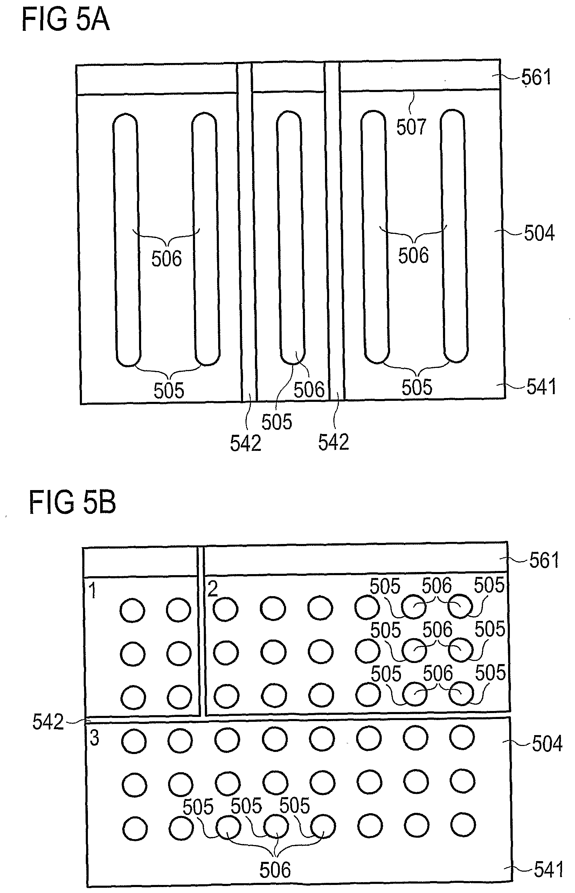

Die Figuren 5A und 5B zeigen verschiedene Varianten für die Unterteilung eines optoelektronischen Halbleiterkörpers in verschiedene Teilbereiche in einer schematischen Draufsicht während des Herstellungsprozesses. Dargestellt sind zudem verschiedene Formen des Durchbruchs 505 und des dadurch freigelegten Materials der aktiven Schicht 506. In einem Randgebiet des jeweiligen Halbleiterkörpers befinden sich zudem Kontaktelemente 507, welche später Teil der Kontaktpanele 561 bilden. Die Durchbrüche 505 sind in dieser Ausgestaltung grabenförmig ausgeführt und durchdringen die isolierende Schicht 541, sowie die zweite Schicht und die aktive Zone der Halbleiterschichtenfolge. Des Weiteren ist der Halbleiterkörper durch die Gräben 542 in insgesamt drei Teilbereiche unterteilt, wobei der mittlere Teilbereich eine deutlich kleinere Ausdehnung aufweist. Durch eine entsprechende Verschaltung von Anschlussschichten sowie eine äußere externe Beschaltung kann eine beliebige Form von Serien- und Parallelschaltungen durch die dargestellten Bereiche realisiert werden.

In der Ausführungsform gemäß Figur 5B sind die Durchbrüche 505 in Form von regelmäßig angeordneten Kreisen ausgebildet. Diese durchdringen die Isolierschicht 504 und die darunter liegende zweite Schicht und aktive Zone der Halbleiterschichtenfolge 541. Auch in diesem Ausführungsbeispiel sind Gräben 542 vorgesehen, die den optoelektronischen Halbleiterkörper in verschieden große Teilbereiche aufspalten. In diesem Ausführungsbeispiel erfolgt eine Verschaltung derart, dass jeweils einer der beiden Teilbereiche 1 und 2 entweder für sich genommen mit der für den Betrieb notwendigen Energie versorgt wird oder in Form einer Serienschaltung mit dem Teilbereich 3 verschaltet wird. Diese Verschaltung kann dabei je nach gewünschtem Anwendungsfall seriell oder parallel erfolgen.

Die vorgeschlagene Erfindung, einen Halbleiterkörper durch isolierende Unterteilung in verschiedene Teilbereiche aufzuspalten und anschließend mittels geeigneter Herstellung von Anschlussschichten diese Teilbereiche in Form einer Serienschaltung oder Parallelschaltung zu verschalten ist nicht auf die hier dargestellten Ausführungsbeispiele beschränkt. Vielmehr umfasst sie jede Kombination möglicher Verschaltungen und hierbei insbesondere die Ausgestaltung der verschiedenen Anschlussschichten. Durch eine entsprechende Strukturierung und Erzeugung der Anschlussschichten nach der Herstellung der Halbleiterschichtenfolge kann eine beliebige Verschaltung eines Halbleiterkörpers erzeugt werden.

Die Herstellung eines einzelnen Halbleiterkörpers und die spätere Unterteilung in verschiedene Teilbereiche ermöglicht eine kostengünstige Fertigung bei einer gleichzeitigen Steigerung der Lichteffizienz durch die geometrisch nahe Ausgestaltung. Durch die Verwendung von LED-Strukturen mit mehreren pn-Übergängen so genannte gesteppte LEDs lässt sich eine elegante Kombination aus Serien- und Parallelschaltungen erreichen. Insbesondere kann eine Verschaltung in der Epitaxieschicht erfolgen, wobei zudem die Verwendung von leitfähigen Trägermaterialien möglich ist.

## Patentansprüche

1. Optoelektronischer Halbleiterkörper umfassend:
- eine im Wesentlichen flächige Halbleiterschichtenfolge (20) mit einer ersten und einer zweiten Hauptseite, die eine zur Erzeugung elektromagnetischer Strahlung geeignete aktive Schicht (22) aufweist,
- bei der die erste Hauptseite zur Emission elektromagnetischer Strahlung vorgesehen ist;
- ein zumindest die aktive Schicht der Halbleiterschichtenfolge durchtrennender Graben (42) zur Unterteilung der aktiven Schicht der Halbleiterschichtenfolge in wenigstens zwei elektrisch isolierte aktive Teilschichten (22, 22');
- jeweils eine auf der zweiten Hauptseite angeordnete erste und zweite Anschlussschicht (50, 60) zur Kontaktierung der aktiven Teilschichten, wobei die ersten und zweiten Anschlussschichten, die jeweils die wenigstens zwei aktive Teilschichten kontaktieren, derart miteinander elektrisch leitend gekoppelt sind, dass die wenigstens zwei aktive Teilschichten eine Serienschaltung bilden,
**dadurch gekennzeichnet, dass** die erste Anschlussschicht und die zweite Anschlussschicht und eine zwischen der ersten Anschlussschicht und der zweiten Anschlussschicht liegende elektrisch isolierende Trennschicht (45) lateral überlappen.

2. Optoelektronischer Halbleiterkörper nach Anspruch 1, bei dem die erste Anschlussschicht zur Kontaktierung einer ersten der wenigstens zwei aktiven Teilschichten mit der zweiten Anschlussschicht zur Kontaktierung einer zweiten der wenigstens zwei aktiven Teilschichten elektrisch leitend verbunden ist.

3. Optoelektronischer Halbleiterkörper nach einem der Ansprüche 1 bis 2, bei dem die erste und/oder die zweite elektrische Anschlussschicht einen von einer der wenigstens zwei aktiven Teilschichten in Richtung zu der zweiten Hauptseite hin emittierten Teil der elektromagnetischen Strahlung in Richtung der ersten Hauptseite reflektieren.

4. Optoelektronischer Halbleiterkörper nach einem der Ansprüche 1 bis 3, bei dem zwischen der Halbleiterschichtenfolge und der ersten und/oder der zweiten elektrischen Anschlussschicht zumindest stellenweise eine halbleitende oder elektrisch isolierende Spiegelschicht angeordnet ist.

5. Optoelektronischer Halbleiterkörper nach Anspruch 4, bei dem die halbleitende oder elektrisch isolierende Spiegelschicht eine Mehrzahl von Öffnungen aufweist und die erste und/oder die zweite elektrische Anschlussschicht durch die Öffnungen zu der Halbleiterschichtenfolge verlaufen.

6. Optoelektronischer Halbleiterkörper nach einem der Ansprüche 4 oder 5, bei dem die halbleitende oder elektrisch isolierende Spiegelschicht 50 % oder mehr der zweiten Hauptseite der Halbleiterschichtenfolge bedeckt.

7. Optoelektronischer Halbleiterkörper nach einem der Ansprüche 1 bis 6, bei dem die Halbleiterschichtenfolge eine der zweiten Hauptseite benachbarte Stromaufweitungsschicht, insbesondere ein leitfähiges Oxid aufweist.

8. Optoelektronischer Halbleiterkörper nach einem der Ansprüche 1 bis 7, bei dem erste und zweite Anschlussschicht zur Kontaktierung einer Teilschicht der Schichtenfolge jeweils einen Kontaktbereich aufweist, der zur elektrischen Kontaktierung des Halbleiterkörpers von der zweiten Hauptseite geeignet ist.

9. Optoelektronischer Halbleiterkörper nach einem der Ansprüche 1 bis 8, bei dem die erste und zweite Anschlussschicht jeweils ein Teilelement umfasst, das eine außerhalb des Halbleiterkörpers angeordnete Zuleitung bildet und mit einem Kontakt auf der Oberfläche des Halbleiterkörpers verbunden ist.

10. Verfahren zur Herstellung eines optoelektronischen Halbleiterkörpers, umfassend:
- Epitaktisches Aufwachsen einer Halbleiterschichtenfolge (20) auf einem Aufwachssubstrat, wobei die Halbleiterschichtenfolge eine zur Erzeugung von elektromagnetischer Strahlung geeignete aktive Schicht (22) aufweist und zur Emission elektromagnetischer Strahlung von einer ersten Hauptseite vorgesehen ist;
- Ausbilden eines elektrisch isolierenden Grabens (42) zumindest in der aktiven Schicht der Halbleiterschichtenfolge zur Unterteilung in wenigstens zwei aktive Teilschichten (22, 22');
- Aufbringen einer ersten elektrischen Anschlussschicht (50) an einer der ersten Hauptseite abgewandten Seite der Halbleiterschichtenfolge zur Kontaktierung der aktiven Schicht
- Ausbilden einer elektrisch isolierenden Trennschicht (45) auf der ersten elektrischen Anschlussschicht an der der ersten Hauptseite abgewandten Seite der Halbleiterschichtenfolge; und
- Aufbringen einer zweiten elektrischen Anschlussschicht (60) auf die Trennschicht an der der ersten Hauptseite abgewandten Seite der Halbleiterschichtenfolge, wobei
- die Anschlussschichten wenigstens zwei aktive Teilschichten unter Bildung einer Serienschaltung kontaktieren, **dadurch gekennzeichnet, dass** die erste elektrische Anschlussschicht, die Trennschicht und die zweite elektrische Anschlussschicht zumindest teilweise lateral überlappend ausgebildet werden.

11. Verfahren nach Anspruch 10, weiter umfassend ein:
- Ausbilden eines Durchbruchs in der aktiven Schicht;
- Ausbilden eines Teilbereichs der zweiten elektrischen Anschlussschicht in dem Durchbruch, wobei die zweite elektrische Anschlussschicht mittels der Trennschicht von der ersten elektrischen Anschlussschicht elektrisch isoliert wird.

12. Verfahren nach einem der Ansprüche 10 bis 11, wobei die erste elektrische Anschlussschicht reflektierend ausgebildet wird.

13. Verfahren nach einem der Ansprüche 10 bis 12, bei der in der Trennschicht ein Durchbruch eingearbeitet wird, der die erste Anschlussschicht, die eine erste aktive Teilschicht kontaktiert mit einer der zweiten Anschlussschicht elektrisch leitend verbindet, der eine zweite aktive Teilschicht kontaktiert.

14. Verfahren nach einem der Ansprüche 10 bis 13, weiter umfassend:
- Ausbilden eines ersten Kontaktpanels auf der der ersten Hauptseite abgewandten Seite, das die erste Anschlussschicht kontaktierend die erste aktive Teilschicht elektrisch kontaktiert; und
- Ausbilden eines zweiten Kontaktpanels auf der der ersten Hauptseite abgewandten Seite, das die zweite Anschlussschicht kontaktierend die zweite aktive Teilschicht elektrisch kontaktiert.

## Claims

1. Optoelectronic semiconductor body comprising:
- a substantially planar semiconductor layer sequence (20) having a first and a second main side, which has an active layer (22) suitable for generating electromagnetic radiation,
- wherein the first main side is provided for emitting electromagnetic radiation;
- a trench (42) that severs at least the active layer of the semiconductor layer sequence and serves for subdividing the active layer of the semiconductor layer sequence into at least two electrically insulated active partial layers (22, 22');
- respectively a first and second connection layer (50, 60) arranged on the second main side and serving for making contact with the active partial layers, wherein the first and second connection layers that respectively make contact with the at least two active partial layers are electrically conductively coupled to one another in such a way that the at least two active partial layers form a series circuit,
**characterized in that** the first connection layer and the second connection layer and an electrically insulating separating layer (45) lying between the first connection layer and the second connection layer laterally overlap.

2. Optoelectronic semiconductor body according to Claim 1, wherein the first connection layer for making contact with a first of the at least two active partial layers is electrically conductively connected to the second connection layer for making contact with a second of the at least two active partial layers.

3. Optoelectronic semiconductor body according to any of Claims 1 to 2, wherein the first and/or the second electrical connection layer reflect in the direction of the first main side a part of the electromagnetic radiation that is emitted by one of the at least two active partial layers in the direction toward the second main side.

4. Optoelectronic semiconductor body according to any of Claims 1 to 3, wherein a semiconducting or electrically insulating mirror layer is arranged at least in places between the semiconductor layer sequence and the first and/or the second electrical connection layer.

5. Optoelectronic semiconductor body according to Claim 4, wherein the semiconducting or electrically insulating mirror layer has a plurality of openings and the first and/or the second electrical connection layer extend through the openings to the semiconductor layer sequence.

6. Optoelectronic semiconductor body according to either of Claims 4 and 5, wherein the semiconducting or electrically insulating mirror layer covers 50% or more of the second main side of the semiconductor layer sequence.

7. Optoelectronic semiconductor body according to any of Claims 1 to 6, wherein the semiconductor layer sequence has a current spreading layer adjacent to the second main side, in particular a conductive oxide.

8. Optoelectronic semiconductor body according to any of Claims 1 to 7, wherein first and second connection layers for making contact with a partial layer of the layer sequence respectively have a contact region suitable for making electrical contact with the semiconductor body from the second main side.

9. Optoelectronic semiconductor body according to any of Claims 1 to 8, wherein the first and second connection layers respectively comprise a partial element that forms a lead arranged outside the semiconductor body and is connected to a contact on the surface of the semiconductor body.

10. Method for producing an optoelectronic semiconductor body, comprising:
- epitaxially growing a semiconductor layer sequence (20) on a growth substrate, wherein the semiconductor layer sequence has an active layer (22) suitable for generating electromagnetic radiation and is provided for emitting electromagnetic radiation from a first main side;
- forming an electrically insulating trench (42) at least in the active layer of the semiconductor layer sequence for the purpose of subdivision into at least two active partial layers (22, 22');
- applying a first electrical connection layer (50) at a side of the semiconductor layer sequence that is remote from the first main side, for the purpose of making contact with the active layer,
- forming an electrically insulating separating layer (45) on the first electrical connection layer at the side of the semiconductor layer sequence that is remote from the first main side; and
- applying a second electrical connection layer (60) on the separating layer at the side of the semiconductor layer sequence that is remote from the first main side,
wherein
- the connection layers make contact with at least two active partial layers with the formation of a series circuit,
**characterized in that** the first electrical connection layer, the separating layer and the second electrical connection layer are formed such that they laterally overlap at least in part.

11. Method according to Claim 10, further comprising:
- forming a perforation in the active layer;
- forming a partial region of the second electrical connection layer in the perforation, wherein the second electrical connection layer is electrically insulated from the first electrical connection layer by means of the separating layer.

12. Method according to any of Claims 10 to 11, wherein the first electrical connection layer is formed in reflective fashion.

13. Method according to any of Claims 10 to 12, wherein a perforation is worked in the separating layer, which perforation electrically conductively connects the first connection layer, which makes contact with a first active partial layer, to the second connection layer, which makes contact with a second active partial layer.

14. Method according to any of Claims 10 to 13, further comprising:
- forming a first contact panel on the side remote from the first main side, which first contact panel makes electrical contact with the first active partial layer in a manner making contact with the first connection layer; and
- forming a second contact panel on the side remote from the first main side, which second contact panel makes electrical contact with the second active partial layer in a manner making contact with the second connection layer.

## Revendications

1. Corps semi-conducteur optoélectronique comprenant :
- une séquence sensiblement plane de couches semi-conductrices (20) ayant des première et deuxième faces principales, qui comporte une couche active (22) appropriée pour la génération d'un rayonnement électromagnétique,
- dans lequel la première face principale est prévue pour l'émission d'un rayonnement électromagnétique ;
- une tranchée (42) traversant au moins la couche active de la séquence de couches semi-conductrices pour la subdivision de la couche active de la séquence de couches semi-conductrices en au moins deux couches actives partielles (22, 22') électriquement isolées ;
- des première et deuxième couches de raccordement (50, 60) respectivement disposées sur la deuxième face principale pour la mise en contact des couches actives partielles, dans lequel les première et deuxième couches de raccordement, qui sont respectivement en contact avec les au moins deux couches actives partielles, sont couplées les unes aux autres de manière électriquement conductrice de façon que les au moins deux couches actives partielles forment un circuit série,
**caractérisé en ce que** la première couche de raccordement et la deuxième couche de raccordement et une couche de séparation (45) électriquement isolante se situant entre la première couche de raccordement et la deuxième couche de raccordement se chevauchent latéralement.

2. Corps semi-conducteur optoélectronique selon la revendication 1, dans lequel la première couche de raccordement destinée à être en contact avec une première des au moins deux couches actives partielles est reliée de manière électriquement conductrice à la deuxième couche de raccordement destinée à être en contact avec une deuxième des au moins deux couches actives partielles.

3. Corps semi-conducteur optoélectronique selon l'une quelconque des revendications 1 à 2, dans lequel la première et/ou la deuxième couche de raccordement électrique réfléchissent, dans la direction de la première face principale, une partie du rayonnement électromagnétique émis vers la deuxième face principale par l'une des au moins deux couches actives partielles.

4. Corps semi-conducteur optoélectronique selon l'une quelconque des revendications 1 à 3, dans lequel une couche miroir semi-conductrice ou électriquement isolante est disposée au moins par endroits entre la séquence de couches semi-conductrices et la première et/ou la deuxième couche de raccordement électrique.

5. Corps semi-conducteur optoélectronique selon la revendication 4, dans lequel la couche miroir semi-conductrice ou électriquement isolante comporte une pluralité d'ouvertures et la première et/ou la deuxième couche de raccordement électrique passent/passe à travers les ouvertures vers la séquence de couches semi-conductrices.

6. Corps semi-conducteur optoélectronique selon l'une quelconque des revendications 4 ou 5, dans lequel la couche miroir semi-conductrice ou électriquement isolante recouvre 50 % ou plus de la deuxième face principale de la séquence de couches semi-conductrices.

7. Corps semi-conducteur optoélectronique selon l'une quelconque des revendications 1 à 6, dans lequel la séquence de couches semi-conductrices comporte une couche d'expansion du courant voisine de la deuxième face principale, notamment un oxyde conducteur.

8. Corps semi-conducteur optoélectronique selon l'une quelconque des revendications 1 à 7, dans lequel les première et deuxième couches de raccordement destinées à être en contact avec une couche partielle de la séquence de couches comportent respectivement une zone de contact qui est appropriée être en contact électrique avec le corps semi-conducteur de la deuxième face principale.

9. Corps semi-conducteur optoélectronique selon l'une quelconque des revendications 1 à 8, dans lequel les première et deuxième couches de raccordement comprennent respectivement un élément partiel qui forme une ligne d'alimentation disposée à l'extérieur du corps semi-conducteur et est relié à un contact présent sur la surface du corps semi-conducteur.

10. Procédé de fabrication d'un corps optoélectronique semi-conducteur, comprenant :
- la croissance épitaxiale d'une séquence de couches semi-conductrices (20) sur un substrat de croissance, dans lequel la séquence de couches semi-conductrices comporte une couche active (22) appropriée pour la génération d'un rayonnement électromagnétique et est prévue pour l'émission d'un rayonnement électromagnétique par une première face principale ;
- la réalisation d'une tranchée (42) électriquement isolante, au moins dans la couche active de la séquence de couches semi-conductrices, pour la subdivision en au moins deux couches actives partielles (22, 22') ;
- l'application d'une première couche de raccordement électrique (50) sur une face de la séquence de couches semi-conductrices qui est tournée à l'opposé de la première face principale pour qu'elle soit en contact avec la couche active ;
- la réalisation d'une couche de séparation (45) électriquement isolante sur la première couche de raccordement électrique sur la face de la séquence de couches semi-conductrices qui est tournée à l'opposé de la première face principale ; et
- l'application d'une deuxième couche de raccordement électrique (60) sur la couche de séparation, sur la face de la séquence de couches semi-conductrices qui est tournée à l'opposé de la première face principale, dans lequel
- les couches de raccordement on en contact avec au moins deux couches actives partielles en formant un circuit série,
**caractérisé en ce que** la première couche de raccordement électrique, la couche de séparation et la deuxième couche de raccordement électrique sont réalisées de manière à se chevaucher latéralement au moins partiellement.

11. Procédé selon la revendication 10, comprenant en outre :
- la réalisation d'une traversée dans la couche active ;
- la réalisation d'une section de la deuxième couche de raccordement électrique dans la traversée, dans lequel la deuxième couche de raccordement électrique est électriquement isolée de la première couche de raccordement électrique au moyen de la couche de séparation.

12. Procédé selon l'une quelconque des revendications 10 à 11, dans lequel la première couche de raccordement électrique est réalisée de manière à être réfléchissante.

13. Procédé selon l'une quelconque des revendications 10 à 12, dans lequel une traversée est incorporée dans la couche de séparation, laquelle traversée relie de manière électriquement conductrice la première couche de raccordement, qui est en contact avec une première couche active partielle, à l'une des deuxièmes couches de raccordement, qui est en contact avec une deuxième couche active partielle.

14. Procédé selon l'une quelconque des revendications 10 à 13, comprenant en outre :
- la réalisation d'un premier panneau de contact sur la face qui est tournée à l'opposé de la première face principale, lequel panneau de contact est en contact électrique avec la première couche active partielle en contact avec la première couche de raccordement ; et
- la réalisation d'un deuxième panneau de contact sur la face qui est tournée à l'opposé de la première face principale, lequel panneau de contact est en contact électrique avec la deuxième couche active partielle en contact avec la deuxième couche de raccordement.
